# EUROPEAN PATENT APPLICATION

(11) **EP 4 152 898 A1**
(43) Date of publication of application: **22.03.2023**
(21) Application number: 21197256.7
(22) Date of filing: 16.09.2021
(51) Int. Cl.: H05K 3/00, H05K 3/06, H05K 3/42, H05K 3/40

(54) **FORMING THROUGH HOLE IN COMPONENT CARRIER BY LASER DRILLING BLIND HOLE AND EXTENDING THE LATTER BY ETCHING**

(71) Applicant: AT & S Austria Technologie & Systemtechnik Aktiengesellschaft, 8700 Leoben-Hinterberg (AT)
(72) Inventor: Ifis, Abderrazzaq, 8700 Leoben (AT); Riedler, Jens, 8793 Trofaiach (AT); Herres, Lukas, 8101 Gratkorn (AT); Skrivanek, Felix, 8700 Leoben (AT); Platzer, Julia, 8010 Graz (AT)
(74) Representative: Dilg, Haeusler, Schindelmann Patentanwaltsgesellschaft mbH

(57) **Abstract**

A method of manufacturing a component carrier (100), wherein the method comprises laser drilling a blind hole (102) in a layer stack (104), and subsequently extending the blind hole (102) to a through hole (106) by etching.

## Description

The invention relates to a component carrier and a method of manufacturing a component carrier.

In the context of growing product functionalities of component carriers equipped with one or more electronic components and increasing miniaturization of such components as well as a rising number of components to be mounted on the component carriers such as printed circuit boards, increasingly more powerful array-like components or packages having several components are being employed, which have a plurality of contacts or connections, with ever smaller spacing between these contacts. Removal of heat generated by such components and the component carrier itself during operation becomes an increasing issue. At the same time, component carriers shall be mechanically robust and electrically reliable so as to be operable even under harsh conditions. All these requirements go hand in hand with a continued miniaturization of component carriers and their constituents.

In particular, it may be desired to efficiently form vertical through connections in a component carrier. Such vertical through connections shall be fillable with material in a reliable way.

There may be a need to efficiently manufacture a component carrier with proper reliability.

According to an exemplary embodiment of the invention, a method of manufacturing a component carrier is provided, wherein the method comprises laser drilling a blind hole in a layer stack, and subsequently extending the blind hole to a through hole by etching.

According to another exemplary embodiment of the invention, a component carrier is provided, wherein the component carrier comprises an electrically insulating layer structure, a frontside electrically conductive layer structure directly on a frontside of the electrically insulating layer structure, and a tapering through hole extending through the frontside electrically conductive layer structure and through the electrically insulating layer structure with lateral overhang of the frontside electrically conductive layer structure beyond the frontside of the electrically insulating layer structure at the tapering through hole of not more than 20% (preferably of not more than 10%) of a maximum diameter of the tapering through hole.

In the context of the present application, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, and an IC (integrated circuit) substrate. A component carrier may also be a hybrid board combining different ones of the above mentioned types of component carriers.

In the context of the present application, the term "layer structure" may particularly denote a continuous layer, a patterned layer or a plurality of non-consecutive islands within a common plane.

In the context of the present application, the term "layer stack" may particularly denote a sequence of two or more layer structures formed on top of each other. For instance, layer structures of a layer stack may be connected by lamination, i.e. the application of heat and/or pressure.

In the context of the present application, the term "frontside layer structure" may particularly denote a layer structure on a frontside of a layer stack opposing a backside thereof. For instance, the frontside may be defined as the side of a layer structure or layer stack at which a processing stage is carried out. For instance, the frontside may be defined as a side from which a laser beam impacts a layer structure or a layer stack during laser drilling. Consequently, the frontside may be the side at which a tapering hole has a larger diameter compared to the backside.

In the context of the present application, the term "tapering hole" may particularly denote a hole having a tapering shape, i.e. having a wider diameter at one end compared to a narrower diameter at the opposing other end. From the end with the wider diameter to the other end with the narrower diameter, the diameter of the tapering hole may be reduced continuously and/or stepwise. A tapering shape of a hole may be a result from an energy impact of one or more laser beams which may be irradiated onto one of the two opposing main surfaces of a layer stack. In a cross-sectional view, a tapering through hole may for instance have a trapezoidal shape with straight slanted sidewalls, or may narrow with curved sidewalls (for instance in a concave way or in a convex way, or partially concave and partially convex). A tapering hole may be free of a constriction between two opposing axial ends of the tapering hole. Hence, a tapering hole does not have an hourglass shape.

In the context of the present application, the term "blind hole" may particularly denote a hole extending vertically into, but not entirely through a layer stack or an electrically insulating layer structure. Hence, a blind hole has an open top and a closed bottom. Preferably, the blind hole may be formed as a laser blind hole, i.e. may be formed by a laser process.

In the context of the present application, the term "through hole" may particularly denote a hole extending completely through an entire electrically insulating layer structure or a layer stack. Hence, a through hole has an open top and an open bottom. A through hole may be manufactured for instance by a combination of one or more laser shots from the frontside and a subsequent etching process from the backside of a layer structure or a layer stack.

In the context of the present application, the term "laser drilling" may particularly denote forming a hole in a layer stack or a layer structure by subjecting the layer stack or layer structure to a laser beam. Said laser beam may be provided with such a high energy or power that the laser beam energy removes material of the layer stack or layer structure and leaves a hole behind.

In the context of the present application, the term "etching" may particularly denote a subtractive manufacturing process of using a fluidic (in particular liquid and/or gaseous) or plasma medium to remove material to create a layer stack or a layer structure with a desired thickness and/or shape. For example, such a fluidic medium may include one or more baths of (preferably temperature-regulated) etching chemicals, but may also be a plasma. In particular, etching may involve a medium denoted etchant. For example, etching may encompass wet etching, plasma etching, flash etching, desmear etching, etc. For defining a region in the layer stack or layer structure subject to material removal by etching, the layer stack or layer structure may be covered for example with a patterned mask (for instance a photomask), for instance created by lithography.

In the context of the present application, the term "overhang" may particularly denote a length of an electrically conductive layer structure directly adjacent to a hole in the electrically conductive layer structure and a connected electrically insulating layer structure over which length the respective portion of the electrically conductive layer structure hangs freely in a cantilever fashion spaced with regard to the electrically insulating layer structure and is not supported from below by material of the electrically insulating layer structure along the extension of the overhang. An overhang region may also be at least partially filled with a filling medium. What concerns the above statement that overhanging material may be locally not supported, it should be said that the overhang may relate to a substantially resin free area beneath the respective electrically conductive layer structure. However, a person skilled in the art will understand that some residue resin might be even present within a gap relating to the overhang. In order to quantitatively determine or measure the value of the overhang, the length of the substantially resin-free (wherein resin may refer to the electrically insulating layer structure) undercut directly under an overhanging electrically conductive layer structure may be measured (in particular even if it is not the most receding point or total relief below the overhanging electrically conductive layer structure, for example copper layer). In other words, for measuring the overhang, the undercut directly below the electrically conductive layer structure may be measured.

According to an exemplary embodiment of the invention, a tapering through hole is formed in a layer stack of a component carrier without or at least without excessive overhang between an electrically conductive layer structure and an electrically insulating layer structure directly connected therewith, at least at a frontside (and optionally also on a backside). The small-overhang or even overhang-free connection between electrically conductive layer structure and electrically insulating layer structure may be located on the frontside at which the layer stack may be subjected to laser drilling for forming part of the tapering through hole. Thus, the small-overhang or even overhang-free connection may correspond in particular to a wider end of the tapering through hole. A strongly reduced or even zero overhang (or substantially zero overhang) design may be highly advantageous, because it suppresses or prevents undefined or unfilled regions in a through hole, improves the mechanical integrity, suppresses tendencies such as delamination and warpage, and avoids formation of voids in a tapering through hole filled with a filling medium (for instance by plating). Thus, a component carrier with excellent electrical and mechanical reliability may be obtained.

Formation of such a component carrier may be accomplished by a formation of the tapering through hole by a two-stage process: Firstly, a blind hole may be formed in the corresponding layer structure or layer stack by laser drilling from the frontside only. Secondly and thereafter, the laser drilled blind hole may be extended in a vertical direction by an etching process being separate from the laser drilling, so that the impact of an etchant spatially extends the pre-laser drilled blind hole for converting the latter into a partially laser drilled and partially etched through hole. Highly advantageously, the described process flow has turned out to be capable of avoiding an excessive overhang between frontside electrically conductive layer structure and electrically insulating layer structure.

Furthermore, the described through hole formation architecture may advantageously avoid any front-to-backside offset, since only a single laser shot from the frontside may be sufficient. Since no two-sided laser drilling is necessary, the corresponding manufacturing process may be simple and efficient. One of the main shortcomings of conventionally formed laser through holes drilled from both sides is that a front-to-back offset cannot be avoided. Highly advantageously, exemplary embodiments of the present invention may avoid the second laser drilling process from the backside, leading to an offset-free through hole. The smaller a diameter of the via becomes, the higher is the risk of a pronounced offset if a conventional laser through hole method involving laser drilling from both sides is used. Such an offset, which may be entirely prevented according to exemplary embodiments of the invention, may further reduce the reliability and the performance of the whole stack up, and of the obtained component carrier.

Moreover, exemplary embodiments of the invention may enable for the manufacturing of very small vias, in particular below 60 µm diameter, and small annular rings. This is not possible with a conventional laser through hole process, mainly due to the conventionally occurring offset being avoided by exemplary embodiments of the invention. Moreover, other issues, such as an excessive overhang or the low middle diameters leading to inclusions, may make it conventionally complicated to properly fill the vias.

In the following, further exemplary embodiments of the component carrier and the method will be explained.

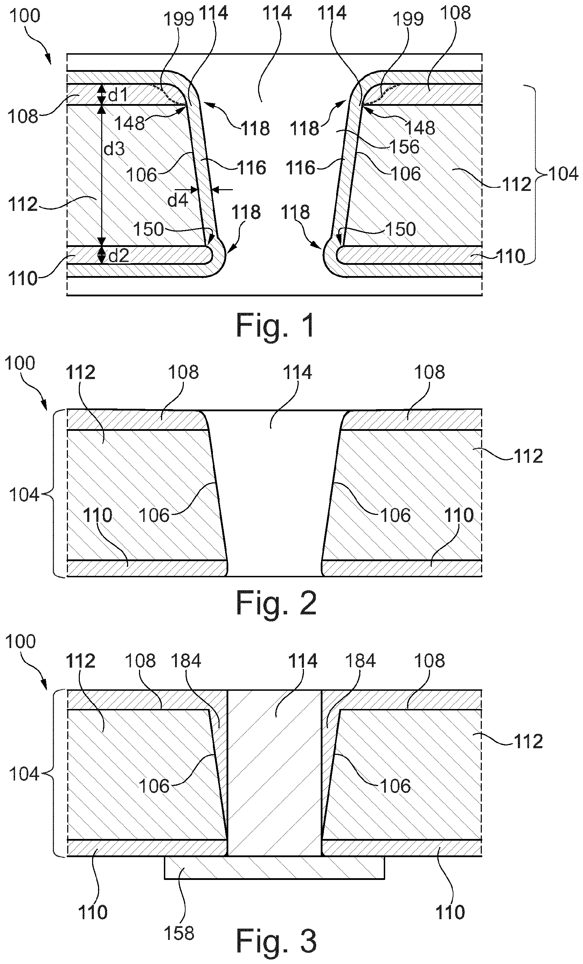

As mentioned above, a small frontside overhang of up to 20% may be possible. Such a minor overhang of the frontside electrically conductive layer in the stack may still allow to obtain a through hole with advantageous properties. A frontside overhang of 20% of the hole diameter is thus alternatively feasible. This can be achieved, for example, by adapting the etching parameters. However, to achieve a proper via filling, the via formation without an overhang is preferable. Moreover, the frontside base copper (i.e. frontside copper material from the copper foil) may be completely gone at the edges of the through hole, extending slightly along the surface, whereas the rest of the surface has still base copper left (see reference sign 199 in Figure 1). It is presently believed that this is because the etching is accelerated at the edges of the hole.

In an embodiment of the component carrier, the tapering through hole extends through the frontside electrically conductive layer structure and through the electrically insulating layer structure without any lateral overhang of the frontside electrically conductive layer structure beyond the frontside of the electrically insulating layer structure at the tapering through hole. Thus, with zero overhang on the frontside, the above described excellent properties may be achieved.

Moreover, an overhang of the backside copper may be allowed and can be larger than 20%. The opening of the backside copper layer is especially useful, so that a proper filling of the hole is possible. Making an opening in the backside copper may allow the plating chemistry to enter the hole from both opposing sides. Thus, the plating of the via is still facilitated and improved.

As already mentioned, formation of a component carrier according to an exemplary embodiment of the invention may be accomplished by a formation of a tapering through hole by a two-stage process in which firstly a blind hole may be formed in the corresponding layer structure or layer stack by laser drilling from the frontside only, before secondly the laser drilled blind hole may be extended in a vertical direction by an etching process. Advantageously, it may also be possible to protect the electrically conductive layer with a protection structure before etching the residual copper at the bottom of the blind hole, for example by a photo-process. Protecting the thick copper foil from the etching by a protection structure may be especially appropriate if it is desired to further structure the surface with a subtractive process. If the surfaces shall be structured with modified semi additive processing (mSAP), no protection by a protection structure is necessary. During the etching process, the thickness of the copper foil may then be reduced, and the thinned copper foil may be used as a remaining seed layer (preferably with a thickness in the range from 2 µm to 5 µm) for additive manufacturing, for example mSAP.

Besides protecting the surface from the etchant, a protection structure (for instance a protective film), such as a structured photoresist, may stabilize the whole layer stack during production of the through hole. This may be especially appropriate for thin dielectric materials, for which methods according to exemplary embodiments may be advantageously used.

In an embodiment, the method comprises laser drilling through a frontside electrically conductive layer structure of the layer stack and into at least part of (in particular through the entire of) an electrically insulating layer structure of the layer stack. Thus, the laser drilling process may be adjusted (in particular in terms of wavelength selection, power selection and/or irradiation time selection) so that the laser beam opens a window in the previously closed frontside electrically conductive layer structure and drills thereafter into the electrically insulating layer structure beneath the frontside electrically conductive layer structure. By laser drilling through two layer structures in a single common shot, blind hole formation may be accomplished in a quick and simple way and thus with high throughput.

In another embodiment, the method comprises forming a window (which may form part of the through hole extending through the layer stack) in a frontside electrically conductive layer structure of the layer stack by etching, and thereafter laser drilling through the window into at least part of the (in particular through the entire) electrically insulating layer structure. In such an embodiment, an additional pre-laser drilling etching stage may be carried out in which a through hole through the frontside electrically conductive layer structure is etched rather than being laser drilled (as in the previously described embodiment). Advantageously, the subsequent laser drilling process may then guide the laser beam through the pre-etched window in the frontside electrically conductive layer structure and may create a blind hole in the electrically insulating layer structure directly beneath without removing metallic material by the laser drilling. Such a laser drilling process may thus be carried out with relatively low energy and/or relatively short irradiation time, and thus in a gentle way without forming undesired artefacts in the layer stack.

In an embodiment, the method comprises laser drilling through an entire electrically insulating layer structure of the layer stack up to a backside electrically conductive layer structure of the layer stack as stop layer. Thus, no or only a part of the thickness of the backside electrically conductive layer structure will be removed by the laser drilling. Generally, it may be challenging to control laser energy and/or irradiation time to precisely define a depth in a layer stack at which the laser drilling stops. When covering a backside of the electrically insulating layer structure with a backside electrically conductive layer structure (for instance a continuous metal layer such as a copper foil), the laser may stop its drilling process when (or shortly after) the backside electrically conductive layer structure is reached. Descriptively speaking, a laser beam may drill significantly more efficiently in an electrically insulating layer structure (in particular comprising a resin such as an epoxy resin, optionally comprising reinforcing particles such as glass fibers or glass spheres) as compared to a metal (such as copper). Hence, a backside laser stop layer in form of the backside electrically conductive layer structure may relax the requirements concerning precision of laser control.

In an embodiment, the method comprises laser drilling through the entire electrically insulating layer structure up to the backside electrically conductive layer structure, and thereafter forming a window (which may form part of the through hole extending through the layer stack) in the backside electrically conductive layer structure by etching (rather than fully by laser processing). Thus, the laser drilling process may form a through hole in the electrically insulating layer structure and a blind hole in the layer stack composed of the traversed electrically insulating structure and the directly connected backside electrically conductive layer structure (the latter remaining continuous after laser drilling). An extension of said blind hole to convert it into a through hole may then be accomplished by a subsequent etching process. This relaxes the requirements in terms of energy, power and irradiation time by the laser beam, since drilling through the backside metal would introduce a significant extra impact of laser energy into the layer stack, and thus the risk of the formation of artefacts. This may be prevented by the separate etching process which completes through hole formation.

In an embodiment, the method comprises laser drilling only from one side, i.e. from the frontside, of the layer stack. Hence, a cumbersome drilling of the layer stack from both opposing main surfaces may be advantageously dispensable. Moreover, front-to-backside offset may be advantageously prevented. One-side drilling may also improve throughput and efficiency of the manufacturing process. Furthermore, this may relax alignment issues which may occur during frontside and subsequent backside laser drilling. Another advantage based on avoiding laser drilling from both sides is that no bottle holes (i.e. not fully drilled holes or locked holes) occur. When using a conventional method with laser drilling of a through hole from both opposing sides, part of the backside copper may be melted by the first laser shot, which may change the structure of the crystal lattice. This changed crystal lattice structure may conventionally lead to complications during the second drilling from the backside, and more energy may be needed to open the copper. In a worst-case scenario, the melted copper can no longer be removed or drilled with the laser which may lead to yield losses.

In an embodiment, the method comprises filling the through hole at least partially with an electrically conductive filling medium. Such an electrically conductive filling medium may enable an electrically conductive connection by the partially or entirely filled through hole. Said filling medium may for instance be a metal, which may be formed for example by plating or using an electrically conductive paste.

In an embodiment, the method comprises filling the through hole at least partially with an electrically conductive filling medium by electroless plating, in particular by forming chemical metal. Electroless plating (which may also be denoted as chemical plating) may refer to a chemical process to create a metal coating, for instance by an autocatalytic chemical reduction of metal cations in a liquid bath. Sputtering may be denoted as a deposition process in which microscopic particles of a solid material are ejected from its surface, after the material is itself bombarded by energetic particles, for instance of a plasma or gas. In particular, at least part of the electrically conductive filling medium may be formed preferably by a chemical process or alternatively by a physical deposition process.

In an embodiment, the method comprises filling the through hole at least partially with an electrically conductive filling medium by electroplating, in particular by galvanic plating, on a seed layer formed by electroless plating.

For example, the seed layer comprises at least one of a group consisting of a chemically deposited seed layer (in particular a palladium base layer and a copper layer grown thereon) or a physically deposited seed layer (in particular a sputtered seed layer). Such a seed layer may function as an electrode to which an electric current may be applied during forming a portion of the electrically conductive filling medium formed by electroplating. Such a seed layer may be formed for example by electroless deposition or sputter deposition (also denoted as sputtering).

For galvanic deposition or electroplating of additional electrically conductive filling medium on the seed layer, water based solutions or electrolytes may be used which contain metal to be deposited as ions (for example as dissolved metal salts). An electric field between a first electrode (in particular an anode) and the preform of the component carrier to be manufactured as second electrode (in particular a cathode) may force (in particular positively charged) metal ions to move to the second electrode (in particular cathode) where they give up their charge and deposit themselves as metallic material on the surface of the through hole, to thereby fill at least part of a remaining volume thereof.

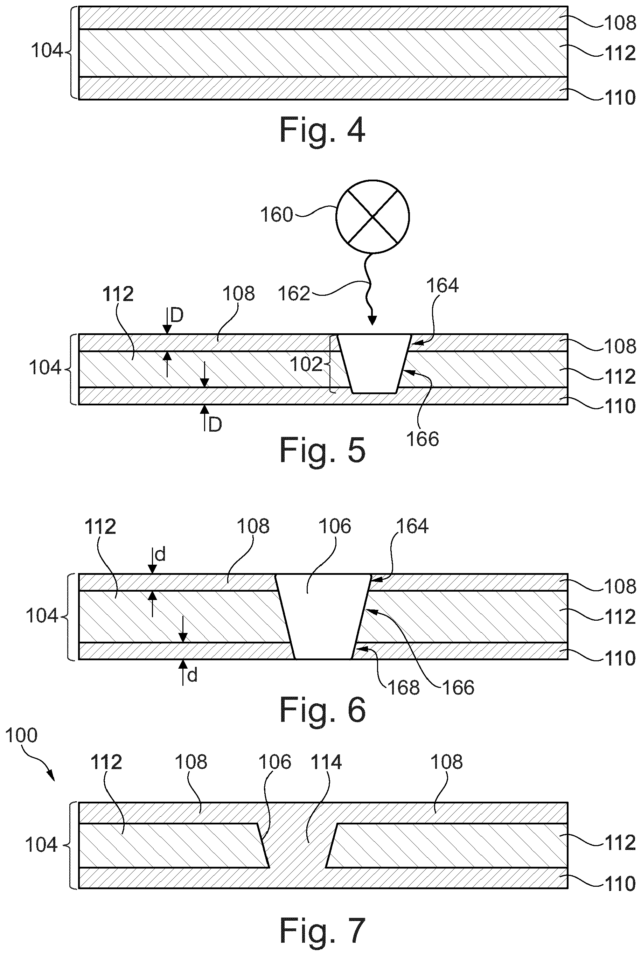

In an embodiment, the method comprises extending the blind hole to the through hole by etching simultaneously two opposing exposed surface portions of a backside electrically conductive layer structure of the layer stack on an electrically insulating layer structure of the layer stack. After laser drilling of a blind hole in a layer stack comprising at least an electrically insulating layer structure and a backside electrically conductive layer structure, which blind hole extends through the entire electrically insulating layer structure and not or at least not entirely through the backside electrically conductive layer structure, both opposing main surfaces of the backside electrically conductive layer structure are exposed in a region of the blind hole (which is to be extended subsequently into a through hole). Highly advantageously, an etch attack of the exposed surface areas of the backside electrically conductive layer structure by an etchant may have a maximum efficiency in the region of the through hole, since only here both opposing main surfaces of the backside electrically conductive layer structure are exposed for the etch attack (see Figure 5). As a consequence, the metal removal rate of removing material of the backside electrically conductive layer structure by etching in the region of the blind hole may be about twice of another metal removal rate where the backside electrically conductive layer structure remains covered by the electrically insulating layer structure. Descriptively speaking, thinning of the backside electrically conductive layer structure by etching may occur in the region of the blind hole with about twice the speed of a thinning of the back-side electrically conductive layer structure apart from the region of the blind hole. Thus, the execution of the etching process may lead advantageously to a through hole completion in the backside electrically conductive layer structure based on the blind hole extending through the electrically insulating layer structure, while maintaining part of the backside electrically conductive layer structure even after completion of the through hole formation.

In an embodiment, it may not be necessary to fully remove the back-side copper in the area of the blind hole. Thus, the backside opening may be smaller than or equal to the front side opening. Descriptively spoken, only a small hole of a few micron diameter in the backside copper may be sufficient to manufacture the through hole allowing nevertheless a proper via filling during a subsequent plating process. When starting with a thin copper foil, the etching process may be additionally facilitated. As mSAP is a method which may advantageously operate with a thin copper foil on a core material, which is used as a seed layer for additively manufacturing copper traces, for example by plating after a photo-process, the described method may be especially advantageously for an mSAP process. Alternatively, as the etching process may also thin a thick copper foil, when unprotected, the resultant core material which previously had a thick copper foil thereon, can subsequently be used as a starting core material for an mSAP processes.

In the following, different ways of structuring the surfaces according to exemplary embodiments of the invention will be explained: In one embodiment, it is possible to start with a thick copper foil, keep it unprotected and use the residual base copper subsequently for an mSAP process. In another embodiment, it is possible to protect the thick base copper either fully or only traces to further use it as a base material for subtractive structuring of the surface. Protecting only the traces may allow to simultaneously open the blind hole and structure the surface. In yet another embodiment, it is possible to start with a thin base copper, protect it and subsequently structure the surfaces after through hole formation by additive manufacturing, for example mSAP.

In an embodiment, the method comprises drilling the blind hole using at least one of a carbon dioxide (COz) laser and an ultraviolet (UV) laser. A carbon dioxide laser may be implemented advantageously in particular when a through hole in a frontside electrically conductive layer structure has already been formed before laser drilling (for instance by lithography and etching) or when no frontside electrically conductive layer structure is present, since a carbon dioxide laser does not or not efficiently remove metallic material (in particular copper) and may therefore leave a backside electrically conductive layer structure intact before etching. In other words, a backside electrically conductive layer structure may form a highly reliable etch stop for a carbon dioxide laser beam. On the other hand, the use of an ultraviolet laser with pronounced metal (in particular copper) removal capability may have the advantage that no pre-patterning of a frontside electrically conductive layer structure is necessary before laser drilling, since a laser drilling process using an ultraviolet laser may drill with a single laser shot through both the frontside electrically conductive layer structure and the electrically insulating layer structure. When using an ultraviolet laser, care should be taken during controlling the laser drilling process with the ultraviolet laser to avoid an excessive impact on the backside electrically conductive layer structure, which should be better removed partially or entirely by etching rather than by laser drilling. This can be ensured by a proper control of the ultraviolet laser drilling process, by correspondingly adjusting power and radiation time.

In an embodiment, before etching, at least one of a frontside electrically conductive layer structure and a backside electrically conductive layer structure of the layer stack has a thickness of not more than 20 µm, in particular in a range from 5 µm to 12 µm. For instance, a copper foil thickness may be up to 20 µm at the beginning, preferably 5 to 12 µm. Furthermore, after etching, the at least one of the frontside electrically conductive layer structure and the backside electrically conductive layer structure of the layer stack may have a thickness in a range from 1 µm to 7 µm, in particular in a range from 2 µm to 5 µm. For example, the range of thicknesses of residual copper after etching (for instance for subsequent use as seed layer) may be in a range from 1 µm to 7 µm, preferably 2 µm to 5 µm. Thus, the etching process may thin, but not remove completely, in particular the backside electrically conductive layer structure, while simultaneously forming a through hole in the backside electrically conductive layer structure in the region of the pre-drilled blind hole in the electrically insulating layer structure.

In a preferred embodiment, a copper foil thickness may be up to 18 µm or even up to 20 µm, preferably 5 µm to 12 µm, at the beginning. An advantageous range of the residual front- and back-side copper after etching, for instance subsequently used as seed layer for growing additional copper thereon, may be preferably in a range from 1 µm to 7 µm, most preferably in a range from 2 µm to 5 µm.

Advantageously, the resulting copper thickness is especially suitable for subsequently structuring the copper using an mSAP process. The resulting thin copper layer can be used as seed layer to additively build copper traces. If not used for an mSAP process, the front- and/or back-side copper layer can alternatively be protected, for example by a photoresist or another protection structure, for example exposing only the blind hole(s).

Protecting a thick copper layer structure before manufacturing the through hole may be especially advantageously, if a subtractive process is used. Before creating the through hole by etching, front- and/or back-side copper can be already covered with a protection structure (such as a photoresist) imaging the circuit design. Thus, for a subtractive process, the through hole and the copper traces can be simultaneously created (rendering the process more efficient by avoiding process stages).

In an embodiment, the etching comprises a first etching process for predominantly removing surface metal material followed by a second etching process predominantly enhancing surface roughness of exposed surface areas of the electrically conductive layer structure(s). It has turned out that a two-stage etching process for extending a pre-laser drilled blind hole into a partially laser drilled and partially etched through hole leads to particularly advantageous properties in terms of avoidance of a frontside overhang and proper adhesion with further layer structures, for instance applied in terms of a subsequent lamination-based buildup. More specifically, the first etching process may predominantly remove metallic material of the backside electrically conductive layer structure for extending the blind hole into a through hole. Furthermore, the second etching process may etch away a potential remaining overhang and may additionally increase the roughness of exposed base metal. Said roughness increase may function for promoting adhesion of subsequently applied layer structures. Two-stage etching may be preferred in certain embodiments in view of the above mentioned advantages. However, it may be preferred in other embodiments to extend the blind hole to a through hole with a single etching stage, which leads to a very low manufacturing effort.

In an embodiment, the first etching process is a desmear process. Such a desmear process may predominantly etch away copper from the backside electrically conductive layer structure (and optionally also from a frontside electrically conductive layer structure). An advantageously implementable desmear process may also remove debris from a pre-drilled laser blind hole, including dielectric resin which has been melted during laser drilling, creating a smear. For desmearing, it may be possible to use for example solutions of sodium permanganate and/or potassium permanganate to desmear and etch pre-drilled blind holes.

In an embodiment, the second etching process is a flash etching process. For instance, flash etching may be embodied as wet etching using an appropriate wet etchant, such as copper chloride. Also a hydrogen peroxide/sulfuric acid system may be implemented for flash etching. Alternatively, flash etching may also be embodied by dry etching, for instance by reactive ion etching (RIE). Reactive ion etching may denote a type of dry etching which may use a chemically reactive plasma to remove material deposited on the processed layer stack. An appropriate plasma may be generated under low pressure or vacuum conditions by an electromagnetic field, wherein high-energy ions from the plasma may attack the surface of the processed layer stack and may react with it. Preferably, it may be possible to use a plasma treatment to enhance resin adhesion by increasing surface roughness.

Although two-stage etching may be advantageous, it may be alternatively possible to extend the blind hole to a through hole with a single etching stage. As mentioned above, it may be possible to not fully, but only partially, remove the backside copper in the area of the blind hole. Thus, an opening of a few micron diameter may be sufficient. Thus, it may be possible to manufacture the through hole with a single etching stage.

In an embodiment, the method comprises forming the through hole without any lateral offset between a center of the through hole on a frontside and a center of the through hole on a backside of the layer stack. By laser drilling from only one side of a layer stack followed by etching, the manufacture of laser through holes without an offset becomes possible.

In an embodiment, the method comprises forming the through hole by laser drilling from a frontside and without laser drilling from a backside of the layer stack. Hence, a method for manufacturing laser through holes with one sided drilling may be provided. Advantageously, such a method may be applied for subtractive and preferably for mSAP (modified semi additive processing) applications.

In an embodiment, the method comprises filling the through hole in the layer stack with an electrically conductive filling medium without bridge plating. In this context, it may be preferred that the layer stack has a thickness below 80 µm. Advantageously, manufacture of copper filled laser through holes may be possible without bridge plating for thin cores with a thickness below 80 µm. The option to avoid bridge plating for filling a through hole significantly simplifies the plating process. Thus, an important advantage of exemplary embodiments is that the plating can optionally be done without the need of a bridge. For vias having a critical aspect ratio (which laser through holes usually have), a copper bridge in the middle of the through hole (where the diameter is thinnest) may be conventionally required. As known by a person skilled in the art, an additional plating stage may be conventionally mandatory for laser through hole processing, as otherwise the filling would not be complete or void free. For conventional laser through holes, a first plating stage may be used to create a bridge in the middle of the hole, followed by a second plating stage to fill the resultant holes formed (below and above the bridge) during the bridge cycle. This means that during the second cycle, the copper grows and thereby fills the through hole starting from the previously obtained copper bridge. By this manner, defect-free filled holes can be conventionally manufactured. However, said conventional process may be complicated and may suffer from yield loss. Advantageously, a method according to exemplary embodiments of the invention does not require a bridge-plating stage, in particular when the core is a thin core (for instance with a core thickness of up to 70 µm to 80 µm) and the hole is not too deep (in particular for thicker cores above 70 µm to 80 µm). This advantage may not be obtained using a conventional laser through hole process. However, when applying exemplary embodiments of the invention to significantly thicker cores, having a deep through hole, a bridging stage may be optionally implemented according to exemplary embodiments of the invention.

In an embodiment, the method comprises laser drilling a first plurality of blind holes in the layer stack from a frontside, subsequently flipping the layer stack, subsequently laser drilling a second plurality of blind holes in the layer stack from a backside, and subsequently extending the first plurality of blind holes and the second plurality of blind holes to a first plurality of through holes and a second plurality of through holes by simultaneously etching. Thus, the manufacturing of the blind holes can be done from both sides of the layer stack. This means that after forming a first portion (for instance half) of the blind holes by laser drilling from one side (fully drilled blind holes, not partially drilled blind holes, related to the number of blind holes), the panel may be rotated, and the rest of the blind holes may be drilled from the other side. This allows for balancing the via density and the copper density respectively. With this manner, critical pitches may be avoided (i.e. critical distances between vias may be avoided, as it is possible to achieve a higher blind hole density) as well as warpage (due to uniform copper distribution). Additionally, the overall panel stability during production may be increased. Drilling a number of holes from one side may be followed by a flipping of the panel and drilling the residual number of holes from the other side. Highly advantageously, the manufacturing of the through holes by etching can then be done simultaneously for all blind holes having a first group of blind holes laser drilled from the front side and a second group of blind holes laser drilled from the backside. The etching process for extending all blind holes into through holes may then be accomplished with a single common simultaneous etching process attacking both opposing main surfaces at the same time. Such a manufacturing process is highly efficient and nevertheless provides through holes with excellent properties.

In an embodiment, the method comprises protecting at least part of an exterior surface of at least one of a frontside electrically conductive layer structure at a frontside of the layer stack and a backside electrically conductive layer structure at a backside of the layer stack by a protection structure at least during the etching. For instance, the method comprises patterning the protection structure before the etching. Protecting the base copper - or one or more defined sections thereof - before through hole formation by etching may prevent excessive removal of copper material during the etching process. Copper residuals of the base copper may then be used for subsequently producing electrically conductive traces, etc.

In an embodiment, the method comprises forming at least one electrically conductive trace based on at least one of the frontside electrically conductive layer structure and the backside electrically conductive layer structure. For instance, formation of traces based on electrically conductive residues on the frontside and/or the backside of the processed layer structure may be carried out by structuring the electrically conductive residues.

In an embodiment, the method comprises forming the at least one electrically conductive trace by patterning at least one of the frontside electrically conductive layer structure and the backside electrically conductive layer structure by etching simultaneously with the extending of the blind hole to the through hole by etching. In other words, the etching process for extending one or more blind holes to one or more through holes may be used at the same time for patterning frontside and/or backside metal for trace formation. Defined portions of the frontside and/or backside may be protected against etching. Hence, it may be possible to simultaneously manufacture the through hole(s) and the copper trace(s) with a subtractive process.

In an embodiment, the method comprises plating the at least one electrically conductive trace simultaneously with at least partially filling the through hole by the plating. Thus, it may be advantageously possible to simultaneously plate the copper traces and fill the holes, in particular with an mSAP (modified semi additive processing) process.

In an embodiment, an opening in the backside electrically conductive layer structure is equal to or smaller than an opening in the frontside electrically conductive layer structure. In particular, the opening in backside base copper can be equal than or smaller to an opening of the frontside copper.

In an embodiment, the through hole has a maximum diameter of not more than 60 µm. Hence, it may be possible to produce one or more small laser vias with a diameter of 60 µm or lower.

In an embodiment, part of the through hole is a laser hole section. Descriptively speaking, the through hole may have the shape of a laser through hole.

In an embodiment, the through hole has continuously tapering sidewalls tapering from its one end to its opposing other end. Consequently, the through hole may be free of an interior bottleneck, which may occur conventionally when forming a through hole by laser drilling from both opposing main surfaces of an electrically insulating layer structure. The absence of a bottleneck simplifies a void-free filling of the through hole during plating.

In an embodiment, a smallest diameter of the through hole is located at an end thereof. Hence, when the laser through hole is formed with continuously tapered sidewalls tapering from one surface to the opposing surface, the smallest diameter may be an outer diameter. In contrast to a conventional sandglass structure of a laser through hole drilled from both opposing main surfaces of an electrically insulating layer structure, issues with inadequate filling with an electrically conductive filling medium by plating do not occur in exemplary embodiments.

In an embodiment, a variation between a thickness of an electrically conductive structure at one end of the through hole and another electrically conductive structure at an opposing other end of the through hole is not more than 15%, preferably not more than 10%. Preferably, a thickness difference between copper structures at both opposing surfaces which does not vary more than 15% may be the result of characteristics during manufacturing. During manufacturing, the copper may become slightly thicker at the bottom surface. However, an increased thickness of up to 15% on one side may be still within specifications and may thus be acceptable.

In an embodiment, the layer stack comprises a backside electrically conductive layer structure directly on a backside of the electrically insulating layer structure. Advantageously, a central electrically conductive layer structure (such as a thin core, which may be made of FR4 material) may be covered on both opposing main surfaces thereof with a respective electrically conductive layer structure (such as a respective copper foil or deposited copper layer). Such a semifinished product may form a proper basis for creating through holes with zero overhang in particular on a frontside by a laser drilling process followed by an etching process (preferably from the frontside and the backside simultaneously).

In an embodiment, the through hole extends also through the backside electrically conductive layer structure. Moreover, a filling medium may also be present in at least part of the through hole portion of the backside electrically conductive layer structure.

In an embodiment, no base material (in particular base metal) of at least one of the frontside electrically conductive layer structure, in particular a metal foil on a core, and the backside electrically conductive layer structure, in particular a further metal foil on the core, is present on at least one edge of the through hole. Finally, also the edges may be covered with copper (material may be always present, such as metal or resin). However, base metal (in particular copper) describes metal (in particular copper) originating from a metal foil on the core. Advantageously, no base copper may be available at the edges. In other words, no base copper (which goes back to a copper layer formed on a dielectric core of the layer structure prior to laser drilling) may be present in an upper end portion and/or in a lower end portion of the through hole. This may lead to a highly reliable component carrier. The mentioned edges may be filled for example by an electrically conductive filling medium in form of a plating structure and/or a paste, but not with base copper.

In particular, the absence of base metal at the edges of the through hole may be related to the slight or even zero overhang. The preferred way of manufacturing the filled through holes is without an overhang on the frontside. However, proper through hole filling may be also possible with a slight overhang. Furthermore, it may be possible that the core material is partially exposed at the edges of the through hole.

In an embodiment, a thickness of the electrically insulating layer structure through which the through hole extends is not more than 80 µm, in particular is in a range from 20 µm to 70 µm. If significantly thicker than 80 µm, an additional bridge plating cycle may be advantageous for filling the through hole with metallic material. However, the avoidance of bridge plating in the presence of a thinner electrically insulating layer structure significantly simplifies the manufacturing process. In particular with relatively thin cores, the described two-stage through hole formation process involving laser drilling and subsequent etching may be of utmost advantage. In particular, such a configuration may allow to create the through hole with a single laser shot, and hence in a highly efficient way. Contrary to conventional approaches, the described manufacturing method for forming a through hole in a thin core will not lead to a disturbing front-to-backside offset, since no double-sided laser treatment is necessary, and consequently no excessive deformation will occur during processing. Advantageously, this may also suppress warpage.

Furthermore, exemplary embodiments of the invention may properly meet requirements for miniaturization. A method according to an exemplary embodiment of the invention may allow for the production of very small laser through holes with small annular rings. Additionally, embodiments of the method may be compliant with an mSAP process. Moreover, embodiments of the method may be particularly appropriate and designed for thin dielectric cores or layers allowing the production of very thin component carriers (in particular PCBs and IC substrates) without bridging during a plating process.

In an embodiment, the component carrier comprising a filling medium filling at least part of the through hole. For example, the filling medium may comprise a seed layer formed directly on a portion of the through hole being delimited by the electrically insulating layer structure. Such a seed layer may be formed by an electroless process and may for instance be chemical copper or sputtered copper. Furthermore, the filling medium may comprise one or more plating structures formed by electroplating, in particular by galvanic plating. Several galvanic plating processes may be executed serially. By taking this measure the degree of filling the through hole may be adjusted by a corresponding process control.

In an embodiment, the filling medium comprises at least one of a group consisting of a plated metal, and a paste, in particular at least one of a metallic paste, a magnetic paste, and a dielectric paste. As mentioned above, a plated metal filling of the through hole may be accomplished by electroless plating and/or electroplating. It is however also possible to press a paste into the through hole for filling purposes. Such a paste may be electrically conductive for enabling an electric signal to be conducted vertically through the paste-type electrically conductive filling medium. It may even be possible to implement a magnetic paste, for instance comprising a permanent magnet such as iron or ferrite. This may allow to implement a magnetic function in the magnetically filled through hole, for instance an inductor function or a transformer function. In yet another embodiment, a dielectric paste may be filled into at least part of the through hole as a dielectric plug. For instance, such a dielectric plug may be highly thermally conductive, for instance when comprising ceramic particles, for contributing to heat removal or heat spreading within the component carrier. Furthermore, such a dielectric plug may be connected with a metallic pad to be connected to a frontside or backside electrically conductive layer structure.

In an embodiment, a wider end of the tapering through hole is located at the frontside. The wider end of the tapering through hole may correspond to the side of the component carrier from which a drilling laser beam impacts on the layer structure during a first stage of the through hole formation process.

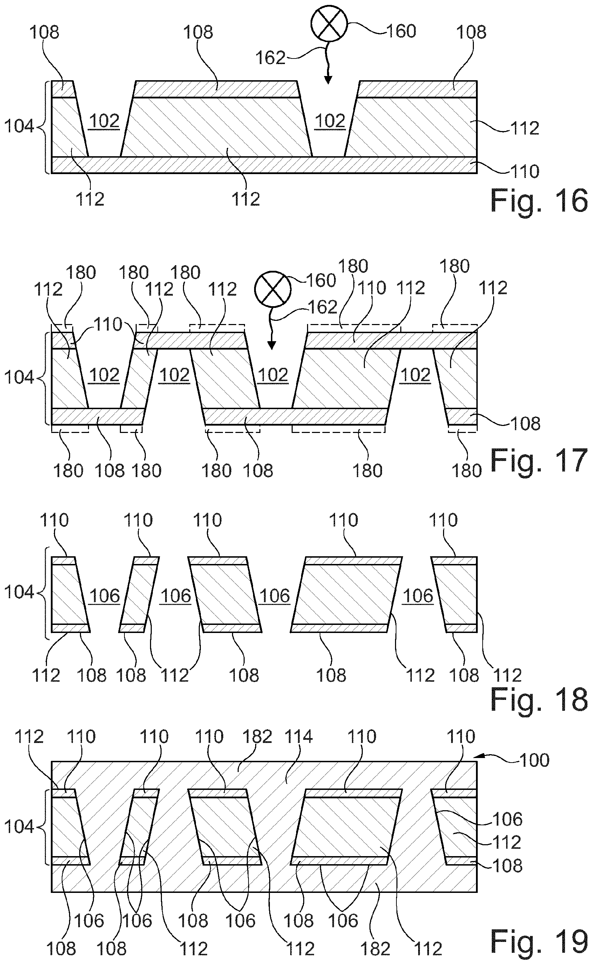

Although the present description focuses on the formation of one through hole in a layer stack, a skilled person will understand that a plurality of through holes may be formed sequentially or simultaneously in such a layer stack by the described concept of forming a blind hole by laser drilling and extending the latter to a through hole by etching. Furthermore, it may be possible to create different subgroups of through holes by laser drilling from both opposing main surfaces to thereby form laser through holes in the layer stack with opposite tapering directions (see Figure 16 to Figure 19).

In an embodiment, the component carrier comprises a stack of at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact. The term "layer structure" may particularly denote a continuous layer, a patterned layer, or a plurality of non-consecutive islands within a common plane.

In an embodiment, the component carrier is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming through holes through the laminate, for instance by laser drilling or mechanical drilling, and by filling them with electrically conductive material (in particular copper), thereby forming vias as through hole connections. Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal, and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) or a photoimageable or dry-etchable organic material like epoxy-based build-up material (such as epoxy-based build-up film) or polymer compounds like polyimide, polybenzoxazole, or benzocyclobutene-functionalized polymers.

In an embodiment, the at least one electrically insulating layer structure comprises at least one of the group consisting of resin (such as reinforced or non-reinforced resins, for instance epoxy resin or bismaleimide-triazine resin), cyanate ester resin, polyphenylene derivate, glass (in particular glass fibers, multi-layer glass, glass-like materials), prepreg material (such as FR-4 or FR-5), polyimide, polyamide, liquid crystal polymer (LCP), epoxy-based build-up film, polytetrafluoroethylene (PTFE, Teflon), a ceramic, and a metal oxide. Reinforcing structures such as webs, fibers, or spheres, for example made of glass (multilayer glass) may be used as well. Although prepreg particularly FR4 are usually preferred for rigid PCBs, other materials in particular epoxy-based build-up film or photoimageable dielectric material may be used as well. For high frequency applications, high-frequency materials such as polytetrafluoroethylene, liquid crystal polymer and/or cyanate ester resins, low temperature cofired ceramics (LTCC) or other low, very low or ultra-low DK materials may be implemented in the component carrier as electrically insulating layer structure.

In an embodiment, the at least one electrically conductive layer structures comprises at least one of the group consisting of copper, aluminum, nickel, silver, gold, palladium, and tungsten. Although copper is usually preferred, other materials or coated versions thereof are possible as well, in particular coated with supra-conductive material such as graphene.

At least one component, which can be embedded in the stack, can be selected from a group consisting of an electrically non-conductive inlay (such as a ceramic inlay, preferably comprising aluminium nitride (AIN)), an electrically conductive inlay (such as a metal inlay, preferably comprising copper or aluminum), a heat transfer unit (for example a heat pipe), a light guiding element (for example an optical waveguide or a light conductor connection), an optical element (for instance a lens), an electronic component, or combinations thereof. For example, the component can be an active electronic component, a passive electronic component, an electronic chip, a storage device (for instance a DRAM or another data memory), a filter, an integrated circuit, a signal processing component, a power management component, an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a substrate, an interposer, or a further component carrier, for example in a board-in-board configuration. The component may be surface mounted on the component carrier and/or may be embedded in an interior thereof. Moreover, also other components, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such as solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), gold (in particular Hard Gold), chemical tin, nickel-gold, nickel-palladium, Electroless Nickel Immersion Palladium Immersion Gold (ENIPIG), etc.

The aspects defined above and further aspects of the invention are apparent from the examples of embodiment to be described hereinafter and are explained with reference to these examples of embodiment.
Figure 1 illustrates a schematic cross-sectional view of a component carrier with tapering through hole filled with a plated filling medium according to an exemplary embodiment of the invention.
Figure 2 illustrates a schematic cross-sectional view of a component carrier with tapering through hole filled with a paste-type filling medium according to another exemplary embodiment of the invention.
Figure 3 illustrates a schematic cross-sectional view of a component carrier with tapering through hole filled with a dielectric plug-type filling medium and connected with a connection pad according to still another exemplary embodiment of the invention.
Figure 4 to Figure 7 illustrate cross-sectional views of structures obtained during carrying out a method of manufacturing a component carrier with a through hole by a laser and etching treatment and by subsequently filling the through hole with electrically conductive filling medium according to an exemplary embodiment of the invention.
Figure 8 to Figure 11 illustrate images of component carriers manufactured according to exemplary embodiments of the invention.
Figure 12 illustrates a cross-sectional view of a component carrier with overhang-free through hole according to an exemplary embodiment of the invention.
Figure 13 illustrates a cross-sectional view of a component carrier with overhang at a frontside of a hole.
Figure 14 and Figure 15 illustrate images of component carriers manufactured according to exemplary embodiments of the invention.
Figure 16 to Figure 19 illustrate cross-sectional views of structures obtained during carrying out a method of manufacturing a component carrier with through holes by a laser and etching treatment and by subsequently filling the through holes with electrically conductive filling medium according to another exemplary embodiment of the invention.

The illustrations in the drawings are schematic. In different drawings, similar or identical elements are provided with the same reference signs.

Before, referring to the drawings, exemplary embodiments will be described in further detail, some basic considerations will be summarized based on which exemplary embodiments of the invention have been developed.

Conventionally, through hole formation in a layer stack of a component carrier to be manufactured involves frontside laser drilling followed by back-side laser drilling. However, such a front-to-back drilling approach may generate an undesired front-to-backside offset involving alignment issues. The offset level may be even higher in case of thin cores due the excessive material removal and deformation. This conventionally occurring offset may also generate an excessive and critical overhang, in particular on the frontside.

What concerns a subsequent plating process for filling a created through hole, the described offset may conventionally generate a small middle diameter of a through hole, which may be prone to undesired void formation. Moreover, the high overhang present in conventional approaches may induce undesired inclusions. Hence, the filling performance of conventional laser drilled through hole may be poor, and significant reliability risks may occur. Further conventional shortcomings are a mandatory bridge plating stage and a yield loss due to the presence of melted copper (for example at bottle holes, i.e. not fully drilled holes or locked holes) when conventional laser through holes are manufactured.

Highly advantageously, a through hole formation architecture according to exemplary embodiments of the invention may reliably avoid the conventional need of front and back drilling, may thereby eliminate the above-described offset issue and may improve the throughput and the reliability of the manufactured component carriers. For instance, a 60% cycle time reduction may be achieved.

According to an exemplary embodiment of the invention, creation of a laser through hole in a layer stack may be accomplished using a combination of partial laser drilling and partial etching (in particular flash etching) leading to a specific tapering via shape. Firstly, a blind hole may be formed in the layer stack by laser drilling from the frontside only, and thereafter the blind hole may be vertically extended by a separate etching process until it becomes a through hole. As a result, an exemplary embodiment obtains a tapering through hole free of any front-to-backside offset, having a low or even zero overhang on the frontside and providing highly reliable and efficiently manufacturable component carriers. Such a manufacturing architecture may be applied particularly advantageously to thin cores. By combining single-sided (and preferably one-shot) laser drilling and subsequent etching for producing a through-hole, tapering through holes may be formed in particular in thin cores without frontside and backside drilling.

According to exemplary embodiments of the invention, a through hole formation architecture for component carriers may be provided which may allow to obtain a zero offset and a minor or even zero overhang tapering through hole without the risk of bottle holes (i.e. not fully drilled holes or locked holes). In particular, embodiments may allow to drill small vias with critical aspect ratio. Advantageously, there is no risk of strongly constricted middle diameters of the through hole, so that the risk of inclusions and voids may be reduced. Furthermore, the manufacturing approach according to exemplary embodiments of the invention may enable pad miniaturization. Component carriers with such tapering through holes may be manufactured with high throughput and low yield loss which allows manufacture on an industrial scale. The manufacturing effort may be low, while simultaneously the trend of miniaturization and the goal of high reliability may be met. Contrary to conventional approaches, no dedicate bridge plating is needed for filling the tapering through hole with a filling medium. This is due to the fact that the tapering through hole formed by a combination of single-sided laser drilling and subsequent etching does not lead to an hourglass shape, which requires bridge formation in conventional approaches with double-sided laser drilling. However, bridge plating may be carried out optionally according to exemplary embodiments, in particular when using thick cores and/or deep holes.

Exemplary embodiments of the invention may increase the capacity in terms of laser processing efficiency and plating performance. In particular, exemplary embodiments of the invention may allow to achieve a higher quality and/or reliability than conventionally manufactured component carriers and may ensure a high miniaturization level on a core.

A major challenge in laser through hole technology is the processing thereof which may conventionally involve double-sided laser drilling. However, drilling from two opposing sides may lead to front to back offset, a challenging middle diameter control and bottle hole defects that are critical to quality and hard to detect during and after processing.

By avoiding double-sided laser drilling without the need of an additional photo process, exemplary embodiments of the invention may enable the formation of a tapering through hole in a layer stack without the above shortcomings. By combining blind hole formation by one-sided laser drilling followed by an etching process for converting the blind hole into a through hole, an easy process is provided in which laser drilling is one-sided while the obtained via nevertheless goes through a base copper.

More specifically, an exemplary embodiment of the invention forms a blind via by laser drilling followed by an accurate flash etching process as a differential etching stage to open the via bottom. Indeed, remaining copper on the bottom of the via may be etched from both sides, and therefore the via may be opened before the base copper gets entirely etched away. Advantageously, no overhang of base copper may occur on the frontside of the tapering through hole, while a flash etching process may lead to a small overhang on the backside.

Advantageously, such an embodiment may involve an accurate selection of a base copper with an appropriate thickness. For instance, the process may start from a 9 µm thick base copper layer and may execute a 5 µm flash etching program. As a result, the vias may be completely opened while there may remain a 4 µm base copper layer on the surface. The remaining copper may strongly help during a subsequent plating process for filling at least part of the tapering through hole with metal.

**Figure 1** illustrates a schematic cross-sectional view of a component carrier 100 with tapering through hole 106 filled with a plated filling medium 114 according to an exemplary embodiment of the invention.

The illustrated component carrier 100 may be a plate-shaped laminate-type component carrier, such as a printed circuit board (PCB). The component carrier 100 comprises a layer stack 104 which comprises a central electrically insulating layer structure 112. Furthermore, a frontside electrically conductive layer structure 108 of the layer stack 104 is formed directly on a frontside of the electrically insulating layer structure 112. Correspondingly, a backside electrically conductive layer structure 110 is formed directly on the backside of the electrically insulating layer structure 112.

The frontside electrically conductive layer structure 108 may be a patterned laminated copper foil. The frontside electrically conductive layer structure 108 may have a thickness dl of for example less than 15 µm, for instance 10 µm. Correspondingly, the backside electrically conductive layer structure 110 may be a further patterned laminated copper foil. The backside electrically conductive layer structure 110 may have a thickness, d2, of for example less than 15 µm, for instance 10 µm.

In the shown embodiment, the electrically insulating layer structure 112 may comprise resin (in particular epoxy resin), optionally comprising reinforcing particles such as glass fibers or glass spheres. For example, the electrically insulating layer structure 112 may be a thin core. For instance, a vertical thickness, d3, of the electrically insulating layer structure 112 may be less than 100 µm, for instance in a range between 20 µm and 60 µm. With such thin cores, reliability issues are conventionally particularly pronounced.

As shown in Figure 1, a tapering through hole 106 extends through the frontside electrically conductive layer structure 108 and through the electrically insulating layer structure 112 without excessive overhang (see reference sign 148). While a zero overhang is preferred, an overhang up to 20%, preferably up to 10%, and most preferably up to 5%, may be allowed on the frontside. In the shown embodiment, the through hole 106 tapers downwardly or towards the backside, so that a wider end of the tapering through hole 106 is located at the frontside and a narrower end of the tapering through hole 106 is located at the backside. Furthermore, reference sign 150 shows a small overhang of the backside electrically conductive layer structure 110 beyond the backside of the electrically insulating layer structure 112 at the tapering through hole 106.

Advantageously, no material of the frontside electrically conductive layer structure 108 and the backside electrically conductive layer structure 110 is present on respective edges 118 of the through hole 106.

As shown as well in Figure 1, an electrically conductive filling medium 114 fills the entire through hole 106 and also covers the electrically conductive layer structures 108, 110 on the frontside of the backside, respectively. The mentioned electrically conductive filling medium 114 comprises plated metal material.

More specifically, the plating-type electrically conductive filling medium 114 comprises a seed layer 116 lining exposed surface portions of the layer structures 108, 110, 112 inside and outside of the through hole 106. In order to form the seed layer 116 which may for instance comprise copper, it is preferable to carry out an electroless deposition procedure covering (in particular after a pre-treatment, for instance with palladium and/or titanium) the sidewalls of the electrically insulating layer structure 112, as well as covering exposed surface portions of frontside electrically conductive layer structure 108 and backside electrically conductive layer structure 110. A thickness, d4, of the seed layer 116 may be for instance 0.5 µm. However, it is also possible that the seed layer 116 has a thickness above 1 µm and/or that several cumulative seed layers are provided. For example, a thickness of a seed layer 116 or a cumulative thickness of a plurality of seed layers may be in a range between 0.5 µm and 5 µm. When multiple seed layers are provided, they may comprise an organic (for instance polymer) layer, a palladium layer, and/or a copper layer.

Subsequently, further electrically conductive material (such as copper) may be deposited on the seed layer 116 by an electroplating procedure, in particular by galvanic plating. Thus, the seed layer 116 may be covered by a thicker electroplating structure 156 of electrically conductive filling medium 114, for instance made of copper. Forming the electroplating structure 156 may be carried out by galvanic plating, preferably following the formation of the seed layer 116. One or a plurality of galvanic plating stages may be executed for this purpose.

As shown by reference signs 199 in Figure 1, the frontside base copper (i.e. frontside electrically conductive layer structure 108 originating from a copper foil) may be completely gone at the edges 118 of the through hole 106, extending slightly along the surface, whereas the rest of the surface has still base copper left. Such a phenomenon may occur since the etching may be accelerated at the edges 118 of the through hole 106. Thus, reference signs 199 show a scenario in which the base copper is fully gone and the electrically insulating layer structure 112 (for instance a dielectric core) is exposed.

For instance, the component carrier 100 according to Figure 1 may be formed by carrying out a manufacturing process as the one described below referring to Figure 4 to Figure 7.

**Figure 2** illustrates a schematic cross-sectional view of a component carrier 100 with tapering through hole 106 filled with a paste-type filling medium 114 according to another exemplary embodiment of the invention.

A difference between the component carrier 100 according to Figure 2 as compared with the component carrier 100 according to Figure 1 is that, according to Figure 2, the electrically conductive filling medium 114 is a metallic paste. Such a metallic paste may be pressed inside the tapering through hole 106. In some cases, such a metallic paste can be cured, for instance thermally. In certain embodiments, the metallic paste may be a magnetic paste which may for instance have permanent magnetic properties. This may allow to provide a component carrier 100 for magnetic applications, for instance for providing an inductor or a transformer functionality in a printed circuit board.

**Figure 3** illustrates a schematic cross-sectional view of a component carrier 100 with tapering through hole 106 filled with a dielectric plug-type filling medium 114 and connected with a connection pad 158 according to still another exemplary embodiment of the invention.

A difference between the component carrier 100 according to Figure 3 as compared with the component carrier 100 according to Figure 2 is that, according to Figure 3, the filling medium 114 comprises a dielectric plug, i.e. is electrically insulating. Consequently, no electric current will be conducted through dielectric plug. For instance, the dielectric plug may be a plug filling partially or entirely the hollow volume of tapering through hole 106 in order to avoid excessive interior voids. For instance, the dielectric plug may be a dielectric paste and/or may also be thermally conductive, for instance may comprise thermally conductive and electrically insulating ceramic particles.

A further difference of the Figure 3 embodiment with dielectric plugin paste and the embodiment of Figure 2 is that, according to Figure 3, an electrically conductive pad 158 is in contact with the lower main surface of the dielectric plug and establishes an electrically conductive connection with the backside electrically conductive layer structure 110. Hence, the pad 158 may function as metal pad creating an electrically conductive connection with other copper layers of the component carrier 100. Furthermore, sidewalls of the through hole 106 may be covered with a metal 184 (such as copper) to achieve a connection.

Figure 4 to Figure 7 illustrate cross-sectional views of structures obtained during carrying out a method of manufacturing a component carrier 100 with a through hole 106 by a laser and etching treatment and by subsequently filling the through hole 106 with an electrically conductive filling medium 114 according to an exemplary embodiment of the invention.

**Figure 4** shows a laminated layer stack 104 composed of a central electrically insulating layer structure 112 covered on a frontside with a frontside electrically conductive layer structure 108 and covered on a backside with a backside electrically conductive layer structure 110. Electrically insulating layer structure 112 may be made of an epoxy resin and optionally reinforcing glass fibers, wherein electrically conductive layer structures 108, 110 may be copper foils.

The electrically conductive layer structures 108, 110 are provided to later ensure a proper plating of a formed through hole 106 and provide improved adhesion properties as compared to a seed layer (see reference sign 116 in Figure 1) only. Moreover, backside electrically conductive layer structure 110 may function as a stop layer during laser drilling, as described below.

Referring to **Figure 5****,** the arrangement according to Figure 4 is subjected to laser drilling from the frontside to thereby form a common blind hole 102 in the frontside electrically conductive layer structure 108 and the electrically insulating layer structure 112 of the layer stack 104. Hence, blind hole 102 extends through only part of the layer stack 104. More precisely, said common blind hole 102 is composed of a window 164 extending through the frontside electrically conductive layer structure 108 and a recess 166 extending through the electrically insulating layer structure 112 of the layer stack 104. As shown, a laser source 160, such as an ultraviolet laser may irradiate a laser beam 162 onto the frontside of layer stack 104, i.e. on the continuous frontside electrically conductive layer structure 108. Hence, laser drilling is executed through the frontside electrically conductive layer structure 108 of the layer stack 104 (for forming window 164) and through the electrically insulating layer structure 112 of the layer stack 104 (forming recess 166). Laser drilling stops at backside electrically conductive layer structure 110, which thereby functions as a stop layer stopping laser drilling in vertical direction. The laser process may be controlled precisely to ensure that the laser beam 162 does not drill through the backside electrically conductive layer structure 110. Thus, a through hole (in form of window 164 and recess 166) is formed in both the frontside electrically conductive layer structure 108 and the electrically insulating layer structure 110 which completely traverses the frontside electrically conductive layer structure 108 of the layer stack 104 and completely traverses the electrically insulating layer structure 112. However, the laser drilling does not remove the backside electrically conductive layer structure 110, at least not over its entire vertical thickness. Thus, the laser drilling drills through the frontside electrically conductive layer structure 108 and the electrically insulating layer structure 112 of the layer stack 104 up to the backside electrically conductive layer structure 110 of the layer stack 104 functioning as stop layer.

Ensuring that the laser drilling process does not extend through the entire backside electrically conductive layer structure 110 may guarantee that a table (not shown) beneath the structure according to Figure 5 is not damaged or destroyed by the laser beam 162. Furthermore, this may avoid laser reflection issues occurring when a laser beam 162 is reflected backwardly.

Advantageously, laser drilling is carried out only from the frontside of the layer stack 104, not from the backside. Thus, a quick and highly efficient laser drilling process may be carried out which leads to a high throughput. Furthermore, no front-to-backside offset occurs due to the only one-sided laser drilling process.

Next, an alternative to the described laser drilling approach will be explained which can be implemented according to other embodiments of the invention: As an alternative to the implemented ultraviolet laser, it is also possible to use a carbon dioxide laser. Since a carbon dioxide laser does not drill through copper material, there is no need for a precise laser control to avoid unintentional laser drilling through the backside electrically conductive layer structure 110. Furthermore, when using a carbon dioxide laser for laser drilling through electrically insulating layer structure 112, i.e. a laser source 160 which does not drill through copper material, a window 164 may firstly be formed in the frontside electrically conductive layer structure 108 prior to laser drilling. Such a window 164 extending through the frontside electrically conductive layer structure 108 may for instance be created by a lithography and etching process which patterns the frontside electrically conductive layer structure 108 before laser drilling. In this context, it is for instance possible to form a photoresist on the frontside electrically conductive layer structure 108 and to pattern the photoresist, for instance using a photomask. Through a recess in the photomask, only a selected surface portion of the frontside electrically conductive layer structure 108 is exposed which can then be subjected to etching for forming the window 164 in the frontside electrically conductive layer structure 108. Thereafter, the laser beam 162 may propagate through the pre-formed window 164 and may drill recess 166 in electrically insulating layer structure 112.

Concluding, the embodiments described referring to Figure 5 may form a blind hole 102 by one-sided laser drilling only. This reduces the setup time and increases the throughput while ensuring that there is no front-to-backside offset, no overhang on the frontside and no creation of undesired bottle holes. Furthermore, a small middle diameter does not occur according to this approach, since no double-sided laser drilling occurs.

Referring to **Figure 6****,** the blind hole 102 may be extended - after having previously completed laser drilling of the blind hole 102 - to a through hole 106 by etching away remaining material of the backside electrically conductive layer structure 110 specifically below the blind hole 102. Hence, the method may first complete laser drilling through the frontside electrically conductive layer structure 108 (or alternatively forming window 164 by lithography and etching) and laser drilling through the electrically insulating layer structure 112 up to the backside electrically conductive layer structure 110, before forming a window 168 in the backside electrically conductive layer structure 110 by etching. Hence, frontside window 164, central recess 166 and backside window 168 may constitute together tapering through hole 106.

Highly advantageously, the described sequence of manufacturing processes may lead to an extension of the blind hole 102 to the through hole 106 by etching simultaneously two opposing exposed surface portions of the backside electrically conductive layer structure 110 of the layer stack 104 on the electrically insulating layer structure 112 of the layer stack 104 in the region of blind hole 102. For accomplishing the extension of the blind hole 102 to the through hole 106, a selective metal etching (in particular copper etching) process may be carried out which removes surface metal. Several surface areas of layer structures 108, 110 are exposed so that metal may be thinned at these surface areas during etching. Optionally, the copper surfaces of layer structures 108, 110 can be protected prior to the etching, for example by a photoresist or other protection structure as etching protection (compare reference sign 180 in Figure 17). The photoresist or other kind of protection structure may be a patterned photoresist covering the whole surface area except the areas where the blind hole 102 is located. Alternatively, the photoresist or other kind of protection structure may be fully patterned to simultaneously perform a subtractive structuring of the surface. However, the portion of the backside electrically conductive layer structure 110 directly beneath the blind hole 102 will experience metal removal during etching with a higher etching rate than other surface areas of layer structures 108, 110. The reason for this is that the etch attack on the backside electrically conductive layer structure 110 directly beneath the blind hole 102 will remove metallic material of the backside electrically conductive layer structure 110 from both opposing exposed surfaces simultaneously. Thus, window 168 will be formed and blind hole 102 will be extended to through hole 106 before the other portions of layer structures 108, 110 are completely removed by etching. Hence, through hole formation may be completed without complete removal of the layer structures 108, 110. This is highly advantageous, since the remaining thinned layer structures 108, 110 contribute significantly to the efficiency of a subsequent through hole filling process by plating. Moreover, the remaining copper of the thinned layer structures 108, 110 can function as a seed-layer if an additive process is subsequently applied, for instance for forming electrically conductive traces. Descriptively speaking, the achieved result may be obtained in view of the executed double sided etching on the via bottom to open through hole 106. For example, before etching, each of the frontside electrically conductive layer structure 108 and the backside electrically conductive layer structure 110 of the layer stack 104 may have a thickness D preferably in a range from 8 µm to 12 µm (see Figure 5). Due to thinning by etching, the frontside electrically conductive layer structure 108 and the backside electrically conductive layer structure 110 of the layer stack 104 may each have a smaller remaining thickness d preferably in a range from 3 µm to 5 µm after etching (see Figure 6).

For example, the mentioned etching comprises a first etching process for removing surface metal material followed by a second etching process enhancing surface roughness. For instance, the first etching process is a desmear process. For example, the second etching process is a flash etching process. Descriptively speaking, the first etching process efficiently removes copper material, whereas the second etching process increases surface roughness and therefore promotes adhesion for subsequent material to be applied on layer structures 108, 110.

Advantageously, the described embodiment leads to an easy and reliable via filling process, as a corresponding chemistry may flow on both sides. Advantageously, no bridging is needed for subsequently filling through hole 106 with filling medium 114. The reason for this is that through hole 106 is tapering and does not have a narrow neck portion, as in hourglass-shaped conventional laser through holes formed by laser drilling from both opposing sides.

Referring to **Figure 7****,** the created through hole 106 may be filled subsequently partially or entirely with an electrically conductive filling medium 114, preferably plated copper. As described above referring to Figure 1, the electrically conductive filling medium 114 may be formed in through hole 106 by firstly forming a seed layer 116 of chemical metal by electroless plating, and by subsequently forming one or more electroplating structures 156 on the seed layer 116 by galvanic plating. During filling the through hole 106 with electrically conductive filling medium 114, the presence of metal surfaces in form of layer structures 108, 110 remaining after etching are of utmost advantage. Thus, the layer structures 108, 110 remaining during plating ensure proper and reliable plating, since electroless copper alone may not adhere enough for guaranteeing an excellent plating performance.

As an alternative to the substantially entire filling of the through hole 106 with electrically conductive filling medium 114, it may also be possible to only plate sidewalls delimiting the through hole 106.

The obtained tapering copper plated vias may be used as vertical through connections, for instance for conducting electric signals within component carrier 100.

Furthermore, it should be said that different embodiments of the invention may be carried out in accordance with a subtractive process or alternatively using a modified semi-additive processing (mSAP) approach on a core.

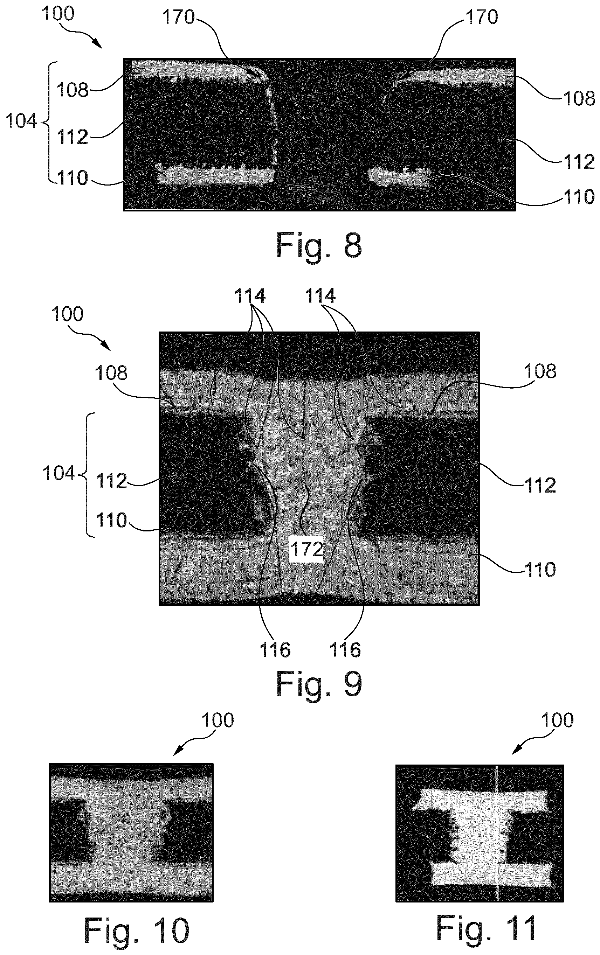

Figure 8 to Figure 11 illustrate images of component carriers 100 manufactured according to exemplary embodiments of the invention.

**Figure 8** shows a manufactured component carrier 100 having excellent properties. Referring to reference sign 170, there is substantially no overhang on the frontside.

Referring to **Figure 9****,** the here illustrated component carrier 100 shows no front-to-back offset thanks to laser drilling from only one side resulting in the shown tapering geometry. More, as illustrated with reference sign 172, no voids occur in an interior of the filling medium 114. Such voids occur frequently in conventionally manufactured component carriers. Also in Figure 9, no overhang exists between the original copper foil on the frontside (i.e. frontside electrically conductive layer structure 108) and the electrically insulating layer structure 110. Figure 9 clearly shows the material interface between frontside electrically conductive layer structure 108 and the plated filling medium 114. Furthermore, no base copper (i.e. copper of layer structures 108, 110) is present in the edges of the through hole 106 both on the frontside and on the backside. In other words, the base copper ends before said edges.

Referring to the additional shown embodiments of component carriers 100 according to **Figure 10** and **Figure 11****,** excellent properties may be obtained. In these practical realizations, it has been possible to create a tapering through hole with 50 µm diameter in a 50 µm thick core without offset, overhang and bottle holes. The scanning image shows that 100% of the holes were open. The filling was easy and reliable without bridge plating. For example, a 110 µm diameter pad can thus be possible without breakout.

In contrast to this, conventional approaches may render it impossible to create a via without front and backside laser drilling. A conventional blind via may frequently have inclusions as the aspect ratio is high. Front to back drilling may generate a considerable offset of for example 20 µm or more. Furthermore, a middle diameter of such conventional through holes may be 80% or less. This may lead to a maximum middle diameter of for example 25 µm or less which does not meet demanding requirements in terms of reliability.

For instance referring to Figure 10 and Figure 11, a variation between a thickness of a copper structure at the lower end of the through hole and another copper structure at the upper end of the through hole may be not more than 15%. Such a slight thickness difference between the copper structures at both opposing surfaces may be the result of characteristics of the manufacturing process. During manufacturing, the copper may become slightly thicker at the bottom surface, but only up to 15% when adjusting the process parameters appropriately. Such variations may be still within specifications. Hence, the mentioned figures show slightly different plating thicknesses of a component carrier 100 manufactured by exemplary embodiments of the invention. Again referring to Figure 10 and Figure 11, the thickness of the copper varies in the region of the via, such as the bottom copper appears to be slightly thicker.

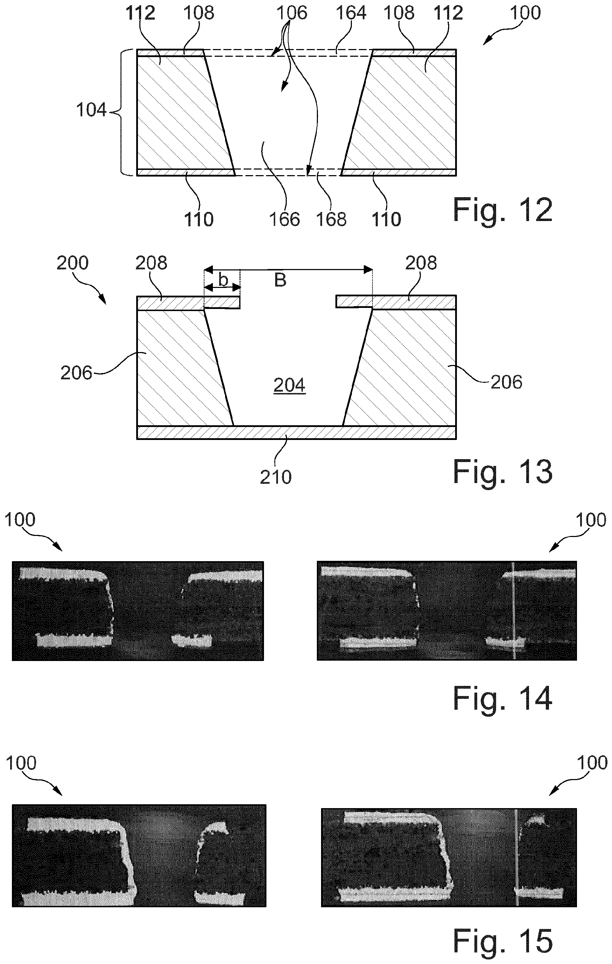

**Figure 12** illustrates a cross-sectional view of a component carrier 100 with overhang-free through hole 106 according to an exemplary embodiment of the invention. Component carrier 100 according to Figure 12 can be manufactured for instance as described above referring to Figure 4 to Figure 7. Hence, Figure 12 shows a tapering through hole 106 after flash etching according to an exemplary embodiment of the invention.

For comparison purposes, **Figure 13** illustrates a cross-sectional view of a component carrier 200 with overhang b at a frontside of a hole 204. Hole 204 is formed in a frontside metal layer 208 and a dielectric layer structure 206. A backside metal layer 210 is closed. Overhang b may be the result of laser processing involving laser reflection at backside metal layer 210. Figure 13 shows a blind via.

As already mentioned, Figure 13 also shows lateral overhang b of frontside metal layer 208 beyond dielectric layer structure 206 at the tapering hole 204. When executing methods according to exemplary embodiments, lateral overhang b may be advantageously not more than 20% of a maximum diameter B of the tapering hole 204, i.e. b:50.2B.

Figure 14 and Figure 15 illustrate images of component carriers 100 manufactured according to exemplary embodiments of the invention. The left-hand side of both Figure 14 and Figure 15 shows a cross-section without etching, and the right-hand side with slight etching to improve contrast. Substructures are better visible on the right-hand side as compared to the left-hand side.

Referring to **Figure 14****,** only a small amount of copper is deposited on sidewalls of the tapering through hole.

Referring to **Figure 15****,** a larger amount of copper is deposited on sidewalls of the tapering through hole.

As can be taken from Figure 14 and Figure 15, component carriers 100 according to exemplary embodiments of the invention do not show any front-to-backside offset, no middle diameter, no bottle holes and no overhang on the frontside.

Figure 16 to Figure 19 illustrate cross-sectional views of structures obtained during carrying out a method of manufacturing a component carrier 100 with a plurality of through holes 106 tapering in opposite directions by a laser and etching treatment and by subsequently filling the through holes 106 with electrically conductive filling medium 114 according to another exemplary embodiment of the invention.

Referring to **Figure 16****,** a first plurality of blind holes 102 are formed in the layer stack 104 by laser drilling from a frontside, i.e. from the frontside electrically conductive layer structure 108.

Referring to **Figure 17****,** the layer stack 104 is subsequently flipped, i.e. is turned upside down by rotation of 180°. Thereafter, a second plurality of blind holes 102 are formed in the layer stack 104 by laser drilling from a backside, i.e. from the backside electrically conductive layer structures 110. Due to the flipping of the layer stack 104 prior to the backside laser drilling, the laser source 160 may be kept on the top side of the layer stack 104 according to Figure 16 and Figure 17. This simplifies the laser drilling process, including alignment.

Referring to **Figure 18****,** the first plurality of blind holes 102 are extended to a first plurality of through holes 106 and the second plurality of blind holes 102 are extended simultaneously to a second plurality of through holes 106 by simultaneously etching. This accelerates the manufacturing process. This may also result in a simultaneous thinning of electrically conductive layer structures 108, 110.

Referring to **Figure 19****,** a plating process can be carried out for filling all through holes 106 simultaneously and for covering the thinned frontside electrically conductive layer structure 108 and the thinned backside electrically conductive layer structure 110 with an electrically conductive filling medium 114, such as copper. Figure 19 shows a readily manufactured component carrier 100. It is also possible that portions of the electrically conductive filling medium 114 on the two opposing main surfaces of component carrier 100 are further patterned, for instance for forming traces 182 electrically coupled to a respective metal filled through hole 106.

Again referring to Figure 17, it is optionally possible to protect at least part of an exterior surface of the frontside electrically conductive layer structure 108 and/or the backside electrically conductive layer structure 110 by a protection structure 180 during the etching. The protection structure 180 may protect electrically conductive material of any of layer structures 108, 110 against removal during etching (in the presence of a protection structure 180, thinning of layer structures 108, 110 during etching, compare Figure 18 with Figure 17, may be prevented for surface portions of layer structures 108, 110 covered with protection structure 180). It is also possible to pattern the protection structure 180 before the etching, so that protection structure 180 may be a patterned protection layer functioning as a local etching inhibitor. In the shown example, the protection structure 180 is patterned so that it is removed at portions of electrically conductive layer structures 108, 110 at which blind holes 102 are extended to through holes 106 by etching.

It is also possible to form one or more electrically conductive traces 182 based on the frontside electrically conductive layer structure 108 and/or the backside electrically conductive layer structure 110. Surface portions of the respective layer structure 108, 110 covered with the patterned protection structure 180 may be prevented from thinning during etching, whereas exposed surface portions of the respective layer structure 108, 110 may be thinned or even entirely removed during the etching. Referring to Figure 19, one or more electrically conductive traces 182 may be formed or thickened simultaneously with the filling of the through hole 106 by the plating, wherein the patterned protection structure 180 may be removed before thickening. In a highly efficient embodiment, it is possible to form one or more electrically conductive traces 182 by patterning the frontside electrically conductive layer structure 108 and/or the backside electrically conductive layer structure 110 by etching simultaneously with the extending of the blind hole 102 to the through hole 106 by etching.

It should be noted that the term "comprising" does not exclude other elements or steps and the "a" or "an" does not exclude a plurality. Also elements described in association with different embodiments may be combined.

It should also be noted that reference signs in the claims shall not be construed as limiting the scope of the claims.

Implementation of the invention is not limited to the preferred embodiments shown in the figures and described above. Instead, a multiplicity of variants are possible which use the solutions shown and the principle according to the invention even in the case of fundamentally different embodiments.

## Claims

1. A method of manufacturing a component carrier (100), wherein the method comprises:
laser drilling a blind hole (102) in a layer stack (104); and
subsequently extending the blind hole (102) to a through hole (106) by etching.

2. The method according to claim 1, wherein the method comprises laser drilling through a frontside electrically conductive layer structure (108) of the layer stack (104) and into at least part of an electrically insulating layer structure (112) of the layer stack (104).

3. The method according to claim 1, wherein the method comprises forming a window (164) in a frontside electrically conductive layer structure (108) of the layer stack (104) by etching, and thereafter laser drilling through the window (164) into at least part of the electrically insulating layer structure (112).

4. The method according to any of claims 1 to 3, wherein the method comprises laser drilling through an entire electrically insulating layer structure (112) of the layer stack (104) up to a backside electrically conductive layer structure (110) of the layer stack (104) as stop layer.

5. The method according to claim 4, wherein the method comprises, after said laser drilling through the entire electrically insulating layer structure (112) up to the backside electrically conductive layer structure (110), forming a window (168) in the backside electrically conductive layer structure (110) by etching.

6. The method according to any of claims 1 to 5, wherein the method comprises laser drilling in the layer stack (104) only from one side of the layer stack (104).

7. The method according to any of claims 1 to 6, wherein the method comprises filling the through hole (106) at least partially with a filling medium (114), in particular with an electrically conductive filling medium.

8. The method according to claim 7, wherein the method comprises filling the through hole (106) at least partially with the electrically conductive filling medium (114) by electroless plating, in particular by forming chemical metal.

9. The method according to claim 7 or 8, wherein the method comprises filling the through hole (106) at least partially with the electrically conductive filling medium (114) by electroplating, in particular by galvanic plating, on a seed layer (116) formed previously by electroless plating.

10. The method according to any of claims 1 to 9, comprising at least one of the following features:
wherein the method comprises extending the blind hole (102) to the through hole (106) by etching in a region of the blind hole (102) simultaneously at two opposing exposed surface portions of a backside electrically conductive layer structure (110) of the layer stack (104) on an electrically insulating layer structure (112) of the layer stack (104);
wherein the method comprises laser drilling the blind hole (102) using at least one of a carbon dioxide laser and an ultraviolet laser;
wherein, before etching, at least one of a frontside electrically conductive layer structure (108) and a backside electrically conductive layer structure (110) of the layer stack (104) has a thickness (D) of not more than 20 µm, in particular in a range from 5 µm to 12 µm;
wherein, after etching, least one of a frontside electrically conductive layer structure (108) and a backside electrically conductive layer structure (110) of the layer stack (104) has a thickness (d) in a range from 1 µm to 7 µm, in particular in a range from 2 µm to 5 µm;
wherein the etching comprises a first etching process for removing surface metal material followed by a second etching process enhancing surface roughness, wherein in particular the first etching process comprises a desmear process and/or the second etching process comprises a flash etching process;
wherein the method comprises forming the through hole (106) without a lateral offset between a center of the through hole (106) on a frontside and a center of the through hole (106) on a backside of the layer stack (104);
wherein the method comprises forming the through hole (106) by laser drilling from a frontside and without laser drilling from a backside of the layer stack (104);
wherein the method comprises filling the through hole (106) in the layer stack (104) with an electrically conductive filling medium (114) without bridge plating, wherein in particular the layer stack (104) has a thickness below 80 µm;
wherein the method comprises: laser drilling a first plurality of blind holes (102) in the layer stack (104) from a frontside, subsequently flipping the layer stack (104), subsequently laser drilling a second plurality of blind holes (102) in the layer stack (104) from a backside, and subsequently extending the first plurality of blind holes (102) and the second plurality of blind holes (102) to a first plurality of through holes (106) and a second plurality of through holes (106), in particular with opposite tapering directions, by simultaneously etching.

11. The method according to any of claims 1 to 10, wherein the method comprises protecting at least part of an exterior surface of at least one of a frontside electrically conductive layer structure (108) at a frontside of the layer stack (104) and a backside electrically conductive layer structure (110) at a backside of the layer stack (104) by a protection structure (180) at least during the etching, wherein in particular the method comprises patterning the protection structure (180) before the etching.

12. The method according to any of claims 1 to 11, wherein the method comprises forming at least one electrically conductive trace based on at least one of a frontside electrically conductive layer structure (108) and a backside electrically conductive layer structure (110).

13. The method according to claim 12, comprising at least one of the following features:
wherein the method comprises forming the at least one electrically conductive trace (182) by patterning at least one of the frontside electrically conductive layer structure (108) and the backside electrically conductive layer structure (110), in particular by etching simultaneously with the extending of the blind hole (102) to the through hole (106) by etching;
wherein the method comprises plating the at least one electrically conductive trace (182) simultaneously with at least partially filling the through hole (106) by the plating.

14. A component carrier (100), which comprises:
an electrically insulating layer structure (112);
a frontside electrically conductive layer structure (108) directly on a frontside of the electrically insulating layer structure (112); and
a tapering through hole (106) extending through the frontside electrically conductive layer structure (108) and through the electrically insulating layer structure (112) with lateral overhang (b) of the frontside electrically conductive layer structure (108) beyond the frontside of the electrically insulating layer structure (112) at the tapering through hole (106) of not more than 20% of a maximum diameter (B) of the tapering through hole (106).

15. The component carrier (100) according to claim 14, comprising at least one of the following features:
wherein the tapering through hole (106) extends through the frontside electrically conductive layer structure (108) and through the electrically insulating layer structure (112) without any lateral overhang of the frontside electrically conductive layer structure (108) beyond the frontside of the electrically insulating layer structure (112) at the tapering through hole (106);
comprising a backside electrically conductive layer structure (110) directly on a backside of the electrically insulating layer structure (112), wherein in particular the through hole (106) extends through the backside electrically conductive layer structure (110), and wherein in particular an opening in the backside electrically conductive layer structure (110) is equal to or smaller than an opening in the frontside electrically conductive layer structure (108);
wherein no base material of at least one of the frontside electrically conductive layer structure (108), in particular a metal foil on a core, and the backside electrically conductive layer structure (110), in particular a further metal foil on the core, is present on at least one edge (118) of the through hole (106);
wherein a thickness (d3) of the electrically insulating layer structure (112) through which the through hole (106) extends is not more than 80 µm, in particular is in a range from 20 µm to 70 µm;
comprising a filling medium (114) filling at least part of the through hole (106), wherein in particular the filling medium (114) comprises at least one of a group consisting of a plated metal, and a paste, in particular at least one of a metallic paste, a magnetic paste, and a dielectric paste;
wherein a wider end of the tapering through hole (106) is located at the frontside;
wherein the through hole (106) has a maximum diameter (B) of not more than 60 µm;
wherein part of the through hole (106) is a laser hole section;
wherein the through hole (106) has continuously tapering sidewalls tapering from its one end to its opposing other end;
wherein a smallest diameter of the through hole (106) is located at an end thereof;
wherein a variation between a thickness of an electrically conductive structure at one end of the through hole (106) and another electrically conductive structure at an opposing other end of the through hole (106) is not more than 15%.
